# EUROPÄISCHE PATENTSCHRIFT

(11) **EP 1 050 202 B1**
(45) Veröffentlichungstag und Bekanntmachung des Hinweises auf die Patenterteilung: **22.06.2005**
(21) Anmeldenummer: 99956027.9
(22) Anmeldetag: 23.11.1999
(51) Int. Cl.: H05K 5/00, H05K 9/00, B60R 16/02

(54) **ANORDNUNG ZUM SCHUTZ VON ELEKTRONISCHEN FUNKTIONSEINHEITEN UND/ODER FUNKTIONSGRUPPEN**
PROTECTIVE ARRANGEMENT FOR ELECTRONIC FUNCTIONAL UNITS AND/OR FUNCTIONAL GROUPS
SYSTEME POUR PROTEGER DES UNITES FONCTIONNELLES ET/OU DES GROUPES FONCTIONNELS ELECTRONIQUES

(30) Priorität: 24.11.1998 DE 19854102; 12.05.1999 DE 19921692
(43) Veröffentlichungstag der Anmeldung: 08.11.2000
(73) Patentinhaber: Continental Teves AG & Co. oHG, 60488 Frankfurt (DE)
(72) Erfinder: LOHBERG, Peter, D-61381 Friedrichsdorf (DE); BURGHARDT, Roland, D-60439 Frankfurt (DE); RINK, Klaus, D-63517 Rodenbach (DE)
(86) Internationale Anmeldenummer: PCT/EP1999/009001
(87) Internationale Veröffentlichungsnummer: WO 2000/032022

(56) Entgegenhaltungen:
- EP-A- 0 481 806
- WO-A-98/12904
- DE-A- 3 244 685
- DE-A- 19 636 496
- US-A- 4 473 755
- US-A- 5 672 844

## Beschreibung

Die Erfindung betrifft ein Krafsfahrzeug-Regelungssystem mit einer Anordnung zum Schutz von elektronischen Funktionseinheiten und/oder Funktionsgruppen, wie Schaltkreisen, Schaltungskomponenten, Verbrauchern, Sensoren und dergleichen vor Störgrößen, wie elektromagnetischen Einstrahlungen, kapazitiven Einkopplungen, Vibrationen und dergleichen. Ein solches System gemäß dem Oberbegriff von Anspruch 1 wird in EP-A-0 481 806 offenbart.

Bei solchen elektronischen Funktionseinheiten und/oder Funktionsgruppen von Kraftfahrzeug-Regelungssystemen, wie Antiblockier-Systemen (ABS), Antriebsschlupfregelsystemen (ASR) und insbesondere Systeme zur Fahrstabilitätsregelung (ESP), müssen die sensierten Meßgrößen störungsfrei erfaßt und ausgewertet werden, da die von den Funktionseinheiten und/oder Funktionsgruppen erfaßten und ausgewerteten Meßgrößen sicherheitsrelevante Bremsvorgänge beeinflussen oder auslösen, die das Fahrverhalten eines Kraftfahrzeugs selbsttätig verändern. Bekanntlich weisen elektronische Funktionseinheiten und/oder -gruppen, die in Kraftfahrzeug-Regelsystemen verwendet werden, Meßwertaufnehmer mit hochempfindlichen niederfrequenten Eingangsstufen als auch digitale Auswerteschaltungen, die mit einem vorgegebenen, stabilen Takt hoher Frequenz betrieben werden, auf. Dabei treten bekanntlich Störsignale mit der Grundfrequenz des Arbeitstaktes auf, die zwar schmalbandig sind, jedoch relativ hohe Amplituden annehmen können. Darüber hinaus kann es zu Störeinkopplungen durch den Potentialversatz eines schaltungsinternen gemeinsamen Bezugsleiters zum Massekörper (Masseschleifen) kommen, als auch zu EMV-Beeinflussungen der empfindlichen Funktionseinheiten und/oder -gruppen durch Mobilfunktelefone und/oder andere Sender, wenn diese mit hoher Sendeleistung in unmittelbarer Nähe der Funktionseinheiten und/oder -gruppen aktiv sind; (siehe z.B. die Druchschrift US-A-5 672 844). Neben diesen elektrischen Störgrößen beeinflussen mechanische Störgrößen, wie Vibrationen, Temperatureinflüsse, Verwindungen und dergleichen die Funktionseinheiten und/oder -gruppen.

Der Erfindung liegt daher die Aufgabe zugrunde, eine Anordnung zur störungsfreien Erfassung, Auswertung und Übertragung von sicherheitskritischen Meßgrößen zu schaffen.

Diese Aufgabe wird erfindungsgemäß durch die Merkmale des Anspruchs 1 gelöst.

Die Erfindung geht von dem Grundgedanken einer Aufteilung der Funktionseinheiten und/oder -gruppen in Teileinheiten und/oder -gruppen mit unterschiedlicher Empfindlichkeit gegenüber den Störgrößen und einer Zuordnung unterschiedlicher Abschirmungen entsprechend der Empfindlichkeit der Teileinheiten und/oder -gruppen aus, wobei mindestens zwei der Abschirmungen sich zu einer Abschirmung mit höherem Wirkungsgrad bzw. Faktor ergänzen. Durch die Aufteilung der Funktionseinheiten und/oder -gruppen in Teileinheiten und/oder -gruppen mit unterschiedlicher Empfindlichkeit gegenüber den Störgrößen ist es vorteilhaft möglich, die Abschirmung gegenüber mechanischen und elektrischen Störgrößen in Abhängigkeit von der Empfindlichkeit der Teileinheiten und/oder -gruppen auszubilden. Dabei ist vorgesehen, daß die Abschirmung, die den Teileinheiten und/oder -gruppen zugeordnet ist, in ihrem Aufbau gleich ist, so daß sich die Abschirmungen in ihrer Wirkung additiv zu einem höheren wirkungsgrad bzw. Faktor ergänzen. Der Erfindung liegt die Erkenntnis zugrunde, daß durch eine gestufte Abschirmung, deren innerer Bereich eine hohe Abschirmung und deren äußerster Bereich eine niedrigere Abschirmung aufweist und die aus einer Stufung der Abschirmung durch immer gleiche Abschirmung von abgeschirmten Bereichen aufbaut ist, unter Zuordnung der Teileinheiten und/oder -gruppen und/oder der Funktionseinheiten und/oder -gruppen je nach Empfindlichkeit gegenüber Störgrößen zu einem Abschirmungsgrad der Abschirmung, sicherheitskritische Meßgrößen störungsfrei erfaßt, ausgewertet und übertragen werden können.

Dabei sind die Teileinheiten und/oder -gruppen mit unterschiedlichen Empfindlichkeiten in jeweils separaten Gehäusen angeordnet. Durch die Anordnung in separaten Gehäusen wird einerseits ein mechanischer Schutz der Teileinheiten und/oder -gruppen erreicht und andererseits läßt sich jedes Gehäuse mit einer gleichen oder unterschiedlichen Abschirmung versehen. Darüber hinaus lassen sich die in jeweils separaten Gehäusen angeordneten Teileinheiten und/oder -gruppen einfach montieren und fertigen.

Vorteilhaft sind die Teileinheiten und/oder -gruppen mit durch die Gehäuse geführten Leitungen verbunden, die jeweils über Kondensatoren kapazitiv an die Gehäuse angeschlossen sind. Die so abgeschirmten separaten Gehäuse schließen hochfrequente Störimpulse gegen Masse kurz, so daß Störeinkopplungen und EMV-Beeinflussungen verhindert werden. Es besteht kein galvanischer Kontakt zwischen den Gehäusen und dem Schaltungsumfeld.

Dadurch daß ein die empfindlichste Teileinheit und/oder -gruppe aufnehmendes erstes Gehäuse von mindestens einem weiteren Gehäuse umgeben ist, in dem eine weitere Teileinheit und/oder -gruppe mit geringerer Empfindlichkeit angeordnet ist, ergänzen sich die Abschirmungen der einzelnen separaten Gehäuse zu einem höheren Gesamtwirkungsgrad bzw. Faktor additiv, wobei die Abschirmung durch das äußere Endgehäuse am geringsten und durch das von allen anderen abgeschirmten Gehäusen umgebene innerste Gehäuse den höchsten Gesamtwirkungsgrad aufweist. Die Anordnung besteht somit aus mehreren elektronischen Teileinheiten und/oder -gruppen, die durch kaskadenartig umschließende Gehäuse separiert sind. Dabei enthält das innere Gehäuse, das von dem äußeren ummantelt wird, elektronische Teileinheiten und/oder -gruppen, die empfindlicher auf elektromagnetische Einstrahlung bzw. kapazitive Einkopplungen reagieren als die Teileinheiten und/oder -gruppen, die im Raum des ummantelnden Gehäuses angeordnet sind.

Nach einer vorteilhaften weiterbildung ist an einem alle Gehäuse umgebenden Endgehäuse ein Steckelement vorgesehen, auf das alle Leitungen der am Endgehäuse angeordneten Teileinheiten und/oder -gruppen geführt sind. In dem Endgehäuse sind neben dem Steckelement (Verbindungsstecker) auch Elemente integriert zur mechanischen Befestigung der gesamten Funktionseinheit und/oder -gruppe an einem Verbraucher, z. B. zur mechanischen Befestigung an dem Fahrzeugchassis eines Kraftfahrzeugs.

Dadurch, daß die dem Steckelement zugeführten Leitungen über jeweils einen Kondensator mit einem Anschlußelement verbunden sind, das über einen Kondensator kapazitiv an das Endgehäuse angeschlossen ist, besteht kein galvanischer Kontakt zwischen diesem Gehäuse und dem elektrischen Schaltungsumfeld. Es wird eine einfache Baueinheit erreicht.

Bevorzugt sind die elektronischen Funktionseinheiten und/oder Funktionsgruppen als geschlossene Anordnung ausgebildet, bei denen mehrere Meßgrößen an einem gemeinsamen Meßort erfaßt werden, vor Ort digitalisiert und ggf. signaltechnisch vorverarbeitet werden und dann über eine entsprechende Schnittstelle, insbesondere über einen Bus an Anschlußteilnehmer dieser Schnittstelle, z. B. ein (ESP-Elektronisches Stabilitäts-Programm) ESP-Steuergerät übertragen werden. Hierzu ist in dem ersten Gehäuse als Teileinheit und/oder -gruppe ein Gierratensensor mit gegenüber Störgrößen hoher Empfindlichkeit angeordnet. Allgemein besitzen solche Gierratensensoren eine bewegliche mechanische Struktur, welche eine zu einer periodischen Schwingung angeregten elektrisch-mechanischen Wandler aufweist. Erfährt der Sensor eine Drehung um eine Achse senkrecht zur angeregten Schwingung, so führt die Bewegung der Schwingung zu einer Coriolis-Kraft, die proportional zur Meßgröße, d.h. der Winkelgeschwindigkeit, ist. Durch die Coriolis-Kraft wird eine zweite zur angeregten Schwingung orthogonale Schwingung in einem mechanisch-elektrischen Wandler angeregt. Diese zweite Schwingung kann durch verschiedene Meßverfahren erfaßt werden, wobei die erfaßte Größe als Maß für die auf den Gierratensensor wirkende Drehrate dient.

Gemäß einer bevorzugten Ausführungsform ist die in einem das erste Gehäuse umgebenden zweiten Gehäuse angeordnete Teileinheit und/oder -gruppe ein Quer- und/oder Längsbeschleunigungssensor und Signalaufbereitungsstufen für den Quer- und/oder Längsbeschleunigungssensor und den Gierratensensor. Diese Teileinheit und/oder -gruppe weist eine geringere Empfindlichkeit gegenüber den vorstehend genannten Störgrößen auf, da deren Signalamplituden größer sind.

In weiterer vorteilhafter Ausgestaltung der Erfindung ist die in einem das erste und zweite Gehäuse umgebenden dritten Gehäuse angeordnete Teileinheit und/oder -gruppe ein Netzwerk, insbesondere ein Signalprozessor, und ein Buscontroller. Das Netzwerk, das die von den Sensoren und den Signalaufbereitungsstufen kommenden Signale digital aufbereitet und für eine Busverbindung CAN (Controller Aerea Network) formatiert, ist auf einer Platine (Montageeinheit) angeordnet.

Grundsätzlich folgt die Erfindung dem Prinzip, daß jeweils ein durch ein Gehäuse geschirmte Teileinheit einer Funktionseinheit und/oder -gruppe mit einer nicht durch dieses Gehäuse geschirmten Teileinheit gemeinsam durch ein beide Teileinheiten gemeinsam ummantelndes Gehäuse umgeben werden, wobei dieses Ummantelungsprinzip kaskadenartig fortgesetzt wird, bis eine geforderte Gesamtabschirmwirkung erreicht ist. Hierbei besteht vorzusgweise keine galvanische Verbindung der Gehäuse zu den Teileinheiten einer Funktionseinheit und/oder -gruppe sondern stets eine kapazitive Verbindung zwischen jedem Gehäuse und den elektrischen Zuführungen in dieses Gehäuse. Als Ausnahme von der strikten galvanischen Trennung können nur die Verbindungen C3 und C7 ausgebildet werden, die nach einem Ausführungsbeispiel als Brücke - d.h. ohne Kondensator - eine direkte Verbindung zwischen dem entsprechenden Gehäuse und der Masse herstellen. Durch diese Ausbildung kann die Abschirmung in bestimmten Fällen verbessert werden, wie empirische Untersuchungen ergaben.

Die Gehäuse sind über schwingungsdämpfende Koppelelemente miteinander verbunden, die ebenfalls sich in ihrer Gesamtwirkung zu einer Gesamtdämpfung mit höherem Wirkungsgrad als jede Einzeldämpfung jedes separaten Gehäuses.

Die vorzugsweise metallischen bzw. elektrisch leitenden Gehäuse sind galvanisch leitend mit dem Fahrzeugchassis verschraubt, wobei durch die kaskadenartige Abschirmung keine unzulässigen elektrischen bzw. hochfrequenten Störeinflüsse innerhalb der abgeschirmten Gehäuse auftreten, die die sicherheitskritischen Meßgrößen verfälschen können. Der direkte metallische Kontakt ermöglicht zugleich eine gute Wärmeableitung der Gehäuse untereinander und damit des Endgehäuses zur Fahrzeugchassis. Gleichzeitig sorgt das metallische Gehäuse für eine ausreichende mechanische Verwindungssteifigkeit, die erforderlich ist, um mit ausreichender Präzision die Gierrate und die Quer- und/oder Längsbeschleunigung zu messen. Durch die Vibrationsdämpfungsmaßnahme wird verhindert, daß geräuschinterne akustische Resonanzerscheinungen und Körperschalleinflüsse über das Fahrzeugchassis das Ausgangssignal des Gierratensensors verfälschen.

Ein Ausführungsbeispiel der Erfindung ist in der Zeichnung dargestellt und wird im folgenden näher beschrieben.

Es zeigt:
- Fig. 1: eine schematische Darstellung der Schaltung mit den abgeschirmten Gehäusen
- Fig. 2: eine Ausführungsform nach Fig. 1.

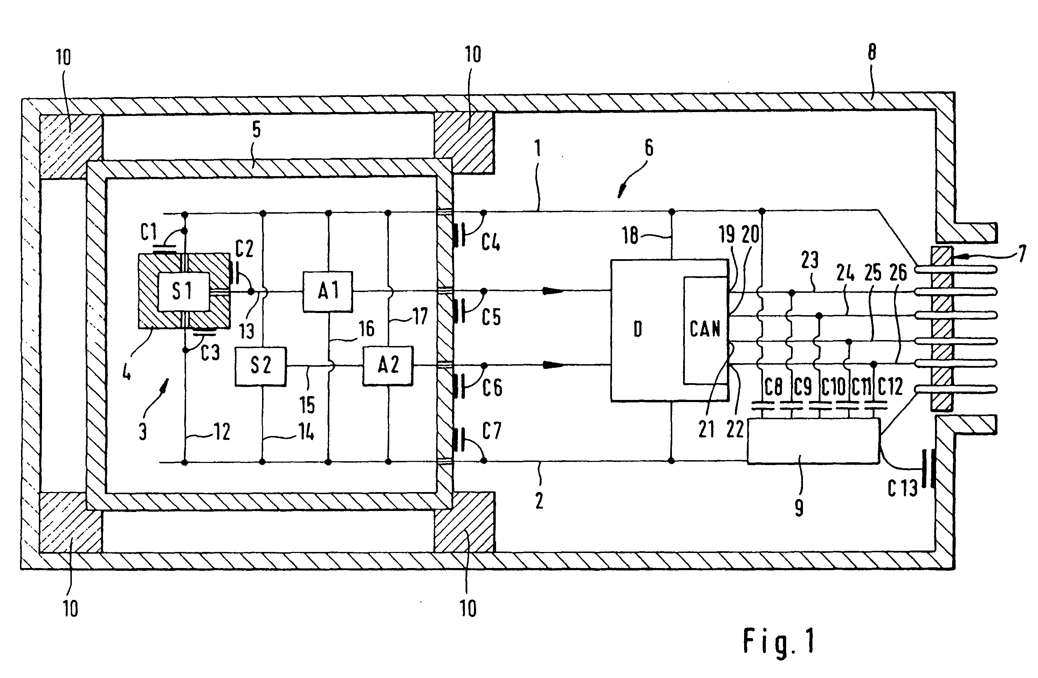

Fig. 1 dient zur Erläuterung der prinzipiellen Anordnung nach der Erfindung. Es sind nur die wesentlichen Komponenten oder Teileinheiten und/oder -gruppen der Funktionseinheiten und/oder -gruppen der Schaltung symbolisch dargestellt. Die Erfindung wird am Beispiel eines Sensorsystems zur Fahrstabilitätsregelung (ESP) von Kraftfahrzeugen beschrieben. Die Anordnung zur Beeinflussung des Fahrverhaltens eines Kraftfahrzeugs weist einen Sensor S1 auf, der aus einem elektrisch-mechanischen Wandler mit vorzugsweise zugeordnetem Anregungsverstärker und einem mechanisch-elektrischen Wandler mit zugeordnetem Signalaufnahmeverstärker besteht. Der Gierratensensor S1 mit dem Signalaufnahmeverstärker und dem Anregungsverstärker ist von einem Gehäuse 4 umgeben und über Leitung 12 parallel an die Zuführungsleitungen 1 und 2 angeschlossen. Leitung 13 verbindet den Gierratensensor S1 mit einer außerhalb des Gehäuses 4 wahlweise vorgesehenen Signalaufbereitungsstufe A1. Sensor S1, der vorzugsweise eine Quarzstimmgabel zur Gierratendetektion mit integriertem Signalaufnahmeverstärker und Anregungsverstärker ist, stellt zugleich die störempfindlichste Funktionseinheit dar, weil der elektrisch-mechanische Wandler von der mechanischen Schwingungsamplitude der Stimmgabel abhängig ist. Der mit dem elektrisch-mechanischen Wandler fest verbundene mechanisch-elektrische Wandler liefert ein Signal mit der gleichen Schwingungsfrequenz wie der angeregte elektrisch-mechanische Wandler, seine Amplitude ist aber proportional von der Drehrate abhängig. Die bei Gierratensensoren eingesetzten Wandlerkörper erzeugen als Regelabweichung eine Ladung als Signal, dessen Empfindlichkeit gegenüber Störgrößen groß ist, da es sehr kleine Amplituden besitzt.

Das Gehäuse 4, das die so ausgebildete Teileinheit S1 umgibt, ist galvanisch leitend ausgebildet und kapazitiv über C1, C2, C3 mit den Leitungen 12 und 13 von S1 verbunden. Nach einer Ausbildungsvariante ist die Verbindung C3 als Brücke B3 - ohne Kondensator - galvanisch leitend mit Leitung 12 verbunden. Das abgeschirmte Gehäuse 4 ist von einem weiteren Gehäuse 5 umgeben, in dem eine weitere Teileinheit angeordnet ist, beispielsweise ein Querbeschleunigungssensor und/oder ein Längsbeschleunigungssensor S2, der aus einem Siliciumelement zur Detektion der Querbeschleunigung besteht. Der Querbeschleunigungssensor S2 ist über Leitung 14 mit den Zuführungsleitungen 1 und 2 verbunden. Über Leitung 15 ist der Querbeschleunigungssensor S2 wahlweise mit einer Signalaufbereitungsstufe A2 verbunden, so daß in dem Gehäuse 5 Querbeschleunigungssensor S2, Signalaufbereitungsstufe A2 und Signalaufbereitungsstufe A1 angeordnet ist. Die Signalaufbereitungsstufen A1 und A2 sind über die Leitungen 16 und 17 an die Zuführleitungen 1 und 2 angeschlossen. Aus dem galvanisch leitenden Gehäuse 5 treten die Leitungen 1,13,15 und 2 aus. Zwischen dieser Funktionseinheit S2, A1 und A2 und dem Gehäuse besteht wiederum kein galvanischer Kontakt. Die Zuführleitungen 1, 13, 15 und 2 sind kapazitiv über Kondensatoren C4, C5, C6 und C7 mit dem Gehäuse 5 verbunden. Nach einer Ausführungsvariante ist die Verbindung C7 als Brücke B7 galvanisch leitend mit Leitung 2 verbunden. Die Teileinheiten S1, S2, A1, A2, sind mechanisch auf einer Platine (Montageeinheit) 3 befestigt.

Das galvanisch leitende Gehäuse 5 ist von einem weiteren Endgehäuse 8 umgeben, das ein Netzwerk D aufweist, welches mit den aus dem Gehäuse 5 herausgeführten Leitungen 13, 15 eingangsseitig verbunden ist. Das Netzwerk D besteht beispielsweise aus einem Analog-Digitalwandler und einem Digital-Analogwandler und einem Controller, der die von der Montageeinheit 3 kommenden Signale digital aufbereitet und für eine Busschnittstelle formatiert. Vorzugsweise ist die Busschnittstelle als CAN-Schnittstelle ausgebildet. Das Netzwerk mit der Busschnittstelle CAN ist über Leitung 18 mit den Zuführungsleitungen 1 und 2 verbunden.

Nach einer vorteilhaften Ausgestaltung entfallen die Signalaufbereitungsstufen A1 und A2, so daß deren Funktion in dem Netzwerk D digital ausgeführt wird. Dabei übernimmt das als digitaler Signalprozessor ausgebildete Netzwerk D die Signalaufbereitung der Sensoren S1 und S2, sowie die Anregung des elektrisch-mechanischen Wandlers des Gierratensensors S1.

Das Endgehäuse 8 weist ein Steckelement 7 auf, zu dem die Signalausgänge 19, 20, 21, 22 der Montageeinheit 6 geführt sind. Die die Signalausgänge 19 bis 22 mit den entsprechenden Steckerstiften verbindenden Leitungen 23 bis 26 sowie die Zuführungsleitung 1 sind jeweils über einen Kondensator C8, C9, C10, C11, C12 mit einem Anschlußelement 9 verbunden. Anschlußelement 9 ist über den Kondensator C13 mit dem äußeren Gehäuse 8 und mit der Zuführungsleitung 2 verbunden. Es besteht kein galvanischer Kontakt zwischen diesem Gehäuse 8 und der Teileinheit D, CAN.

Die Anordnung folgt dem Prinzip, daß eine durch ein Gehäuse 4, 5 geschirmte Teileinheit einer Funktionseinheit mit einem nicht durch dieses Gehäuse 4 oder 5 geschirmten Teileinheit gemeinsam durch ein beide Teileinheiten gemeinsam ummantelndes Gehäuse, z. B. S1 durch geschirmtes Gehäuse 4 und geschirmtes Gehäuse 5 und geschirmtes Gehäuse 8 oder Teileinheit S2, A1, A2 durch geschirmtes Gehäuse 5 und geschirmtes Gehäuse 8, umgeben werden, wobei dieses Ummantelungsprinzip kaskadenartig oder stufenförmig fortgesetzt wird, bis eine geforderte Gesamtabschirmung der unterschiedliche Empfindlichkeiten gegenüber Störgrößen aufweisenden Teileinheiten erreicht ist. Hierbei besteht keine galvanische Verbindung der Gehäuse zu den elektrischen Teileinheiten sondern stets eine kapazitive Verbindung zwischen den Gehäusen 4, 5, 8 und den elektrischen Zuführungen 1, 2, 13, 15, 23, 24, 25, 26 in diese Gehäuse 4, 5 und 8. Die Gehäuse 4, 5 und 8 sind über schwingungstilgende Koppelelemente 10 verbunden, deren Wirkung sich ebenfalls kaskadiert. Das Gehäuse 4 ist vibrationsdämpfend mit dem Gehäuse 5 (nicht näher dargestellt) verbunden und das Gehäuse 5 ist vibrationsdämpfend über schwingungsdämpfende Koppelelemente 10 mit dem Gehäuse 8 verbunden.

Das metallische Endgehäuse 8 wird bevorzugt galvanisch leitend mit dem Fahrzeugchassis eines Kraftfahrzeugs verschraubt, wobei durch die kaskadenartige Schirmung keine unzulässigen elektrischen bzw. hochfrequenten Störeinflüsse auftreten, da über die Abschirmung erreicht wird. Die sicherheitstechnischen Meßgrößen, wie sie für die Fahrstabilisierung eines Kraftfahrzeuges benötigt werden, können nicht verfälscht werden, so daß Fehlanregelungen oder Fehler im Regelprogramm sicher ausgeschlossen werden.

Der direkte metallische Kontakt ermöglicht zugleich eine gute Wärmeableitung vom Endgehäuse 8 zum Fahrzeugchassis. Gleichzeitig sorgt das metallische Endgehäuse 8 in Verbindung mit dem vorstehend beschriebenen Aufbau über weitere Gehäuse 5 und 4, für ausreichende mechanische Verwindungssteifigkeit, die erforderlich ist, um mit ausreichender Präzision eine Gierrate und Querbeschleunigung zu messen. Durch die Vibrationsdämpfungsmaßnahmen wird verhindert, daß gehäuseinterne akustische Resonanzsschwingungen und Körperschalleinflüsse über das Fahrzeugchassis das Ausgangssignals des Sensors S1, insbesondere des mechanisch-elektrischen Wandlers, verfälschen.

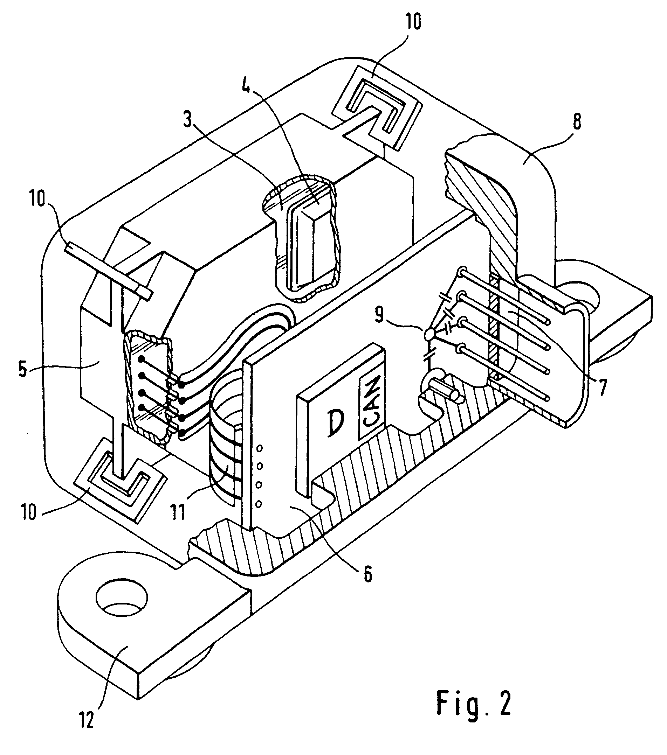

Fig. 2 zeigt eine erfindungsgemäße Ausführungsform, wobei für gleiche Bauteile gleiche Bezugszeichen verwendet sind. Die Lage der in Fig. 1 beschriebenen Funktionseinheiten und/oder -gruppen bzw. Teileinheiten und/oder -gruppen ist durch die Bezugsziffern ersichtlich. In der praktischen Realisierung sind die Kondensatoren C4, C5, C6, C7 als Durchführungskondensatoreh realisiert, ausgebildet. Die Platinen 3 und 6 (Montageeinheiten) sind durch eine flexible Leiterfolie 11 verbunden. Das metallische Endgehäuse 8 wird über Laschen 12 direkt mit dem Fahrzeugchassis eines Kraftfahrzeugs oder an einem metallischen Halter zum Fahrzeugchassis verschraubt. Die Anordnung wird über den Stecker 7 mit dem Kabelbaum verbunden.

## Patentansprüche

1. Kraftfahrzeug-Regelungssystem, mit einer Anordnung zum Schutz von elektronischen Funktionseinheiten und/oder Funktionsgruppen, wie Schaltkreisen, Schaltungskomponenten, Verbrauchern, Sensoren und dergleichen, zum Erfassen und Auswerten von das Fahrverhalten des Kraftfahrzeugs beeinflussenden Meßgrößen, vor elektromagnetischen Einstrahlungen, kapazitiven Einkopplungen, und dergleichen, **dadurch gekennzeichnet, dass** eine Aufteilung der Funktionseinheiten und/oder -gruppen in Teileinheiten und/oder -gruppen (S1; S2, A1, A2; D, CAN) mit unterschiedlicher Empfindlichkeit gegenüber den Störgrößen erfolgt, dass den Teileinheiten und/oder - gruppen mit unterschiedlicher Empfindlichkeit gegenüber den Störgrößen eine unterschiedliche Abschirmung gegen die Störgrößen zugeordnet ist, dass die Abschirmungen (4, 5, 8) als elektrisch leitende Gehäuse ausgebildet sind, dass die Teileinheiten und/oder -gruppen mit unterschiedlicher Empfindlichkeit durch kaskadenartig sich umschließende Gehäuse separiert sind, dass mindestens zwei der Gehäuse sich zu einer Abschirmung (4,5; 5,8) mit höherem Wirkungsgrad bzw. Faktor ergänzen und die Teileinheiten und/oder -gruppen jeweils über aus den Gehäusen herausgeführte Leitungen (1, 2, 12, 14, 23, 24, 25, 26) mit dem Regelungssystem verbunden sind.

2. Kraftfahrzeug-Regelsystem nach Anspruch 1, **dadurch gekennzeichnet, daß** die Teileinheiten und/oder -gruppen mit durch die Gehäuse (4,5,8) geführten Leitungen (1,2,13,15,23,24,25,26) verbunden sind, die jeweils über Kondensatoren (C1, C2, C3; C4, C5, C6, C7; C8 bis C13) kapazitiv oder jeweils über die Kondensatoren (C1,C2,C4,C5,C6; C8 bis C13) kapazitiv und über eine Brücke (B3, B7) galvanisch leitend an die Gehäuse (4,5,8) angeschlossen sind.

3. Kraftfahrzeug-Regelsystem nach einem der Ansprüche 1 oder 2, **dadurch gekennzeichnet, daß** ein die empfindlichste Teileinheit und/oder -gruppe aufnehmendes erstes Gehäuse (4) von mindestens einem weiteren Gehäuse (5 oder 8) umgeben ist, in dem eine weitere Teileinheit und/oder -gruppe (S2, A1, A2) angeordnet ist.

4. Kraftfahrzeug-Regelsystem nach einem der Ansprüche 1 bis 3, **dadurch gekennzeichnet, daß** an einem alle Gehäuse (4, 5) umgebenden Endgehäuse (8) ein Steckelement (7) vorgesehen ist, auf den alle Leitungen (23, 24, 25,26) der im Endgehäuse (8) angeordneten Teileinheiten und/oder -gruppen (D, CAN) geführt sind.

5. Kraftfahrzeug-Regelsystem nach einem der Ansprüche 1 bis 4, **dadurch gekennzeichnet, daß** die dem Steckelement (7) zugeführten Leitungen (1, 22, 23, 24, 25) über jeweils einen Kondensator (C8, C9, C10, C11, C12) mit einem Anschlußelement (9) verbunden sind, das über einen Kondensator (C13) kapazitiv an das Endgehäuse (8) angeschlossen ist.

6. Kraftfahrzeug-Regelsystem nach einem der Ansprüche 1 bis 5, **dadurch gekennzeichnet, daß** die im ersten Gehäuse (4) angeordnete Teileinheit und/oder -gruppe ein Gierratensensor ist.

7. Kraftfahrzeug-Regelsystem nach einem der Ansprüche 1 bis 6, **dadurch gekennzeichnet, daß** die in einem das erste Gehäuse (4) umgebenden zweiten Gehäuse (5) angeordnete Teileinheit und/oder -gruppe ein Querbeschleunigungssensor (S2) und Signalaufbereitungsstufen (A2) für den Querbeschleunigungssensor und den Gierratensensor sind.

8. Kraftfahrzeug-Regelsystem nach einem der Ansprüche 1 bis 7, **dadurch gekennzeichnet, daß** die in einem ersten und zweiten Gehäuse (4, 5) umgebenden dritten Gehäuse (8) angeordnete Teileinheit und/oder -gruppe ein Netzwerk (D), insbesondere ein Signalprozessor, und eine Busschnittstelle ist.

9. Kraftfahrzeug-Regelsystem nach einem der Ansprüche 1 bis 8, **dadurch gekennzeichnet, daß** die Gehäuse (4, 5, 8) über schwingungsdämpfende Koppelelemente (10) miteinander verbunden sind.

10. Kraftfahrzeug-Regelsystem nach einem der Ansprüche 4 bis 9, d**adurch gekennzeichnet, daß** das Endgehäuse (8) in metallischem Kontakt mit einem wärmeableitenden Teil eines Kraftfahrzeuges verbunden ist.

## Claims

1. Motor vehicle control system with an arrangement for protection of electronic functional units and/or functional groups, such as circuits, circuitry components, consumers, sensors, and the like, to detect and evaluate measured quantities influencing the driving performance of the motor vehicle, for protection from electromagnetic radiation, capacitive couplings, and the like,
**characterized in that** a division of the functional units and/or groups into partial units and/or groups (S1; S2, A1, A2; D, CAN) with different sensitivity to the disturbance quantities is provided, **in that** a different screening from the disturbance quantities is assigned to the partial units and/or groups with different sensitivity to the disturbance quantities, **in that** the screenings (4, 5, 8) are configured as electrically conductive housings, **in that** the partial units and/or groups with different sensitivity are separated by housings enclosing themselves in a cascade manner, **in that** at least two of the screenings (4,5; 5,8) complete each other to a screening with a higher efficiency degree or factor, respectively, and the partial units and/or groups are respectively connected to the control system by way of lines (1, 2, 12, 14, 23, 24, 25, 26) led out of the housings.

2. Motor vehicle control system according to claim 1,
**characterized in that** the partial units and/or groups are connected to lines (1,2,13,15,23,24,25,26) guided through the housings (4,5,8), which lines are connected to the housings (4,5,8) capacitively by way of capacitors (C1, C2, C3; C4, C5, C6, C7; C8 to C13) and in a galvanically conducting way by way of a bridge (B3, B7).

3. Motor vehicle control system according to any one of claims 1 or 2,
**characterized in that** a first housing (4) accommodating the most sensitive partial unit and/or group is surrounded by at least one further housing (5 or 8) in which a further partial unit and/or group (S2, A1, A2) is arranged.

4. Motor vehicle control system according to any one of claims 1 to 3,
**characterized in that**, on an end housing (8) surrounding all housings (4,5), a plug-in element (7) is provided, onto which all lines (23, 24, 25, 26) of the partial units and/or groups (D, CAN) arranged in the end housing (8) are led.

5. Motor vehicle control system according to any one of claims 1 to 4,
**characterized in that** the lines (1, 22, 23, 24, 25) led to the plug-in element (7) are each connected via a capacitor (C8, C9, C10, C11, C12) to a connection element (9) which is capacitively connected to the end housing (8) by way of a capacitor (C13).

6. Motor vehicle control system according to any one of claims 1 to 5,
**characterized in that** the partial unit and/or group arranged in the first housing (4) is a yaw rate sensor.

7. Motor vehicle control system according to any one of claims 1 to 6,
**characterized in that** the partial unit and/or group arranged in the second housing (5) surrounding the first housing (4) is a lateral acceleration sensor (S2) and signal processing steps (A2) for the lateral acceleration sensor and the yaw rate sensor.

8. Motor vehicle control system according to any one of claims 1 to 7,
**characterized in that** the partial unit and/or group arranged in a third housing (8) surrounding first and second housings (4, 5) is a network (D), in particular a signal processor, and a bus interface.

9. Motor vehicle control system according to any one of claims 1 to 8,
**characterized in that** the housings (4, 5, 8) are interconnected by way of vibration damping coupling elements (10).

10. Motor vehicle control system according to any one of claims 4 to 9,
**characterized in that** the end housing (8) is connected to a heat-abducting part of a motor vehicle by metallic contact.

## Revendications

1. Système de régulation de véhicule automobile, comportant un dispositif pour la protection d'unités fonctionnelles et/ou groupes fonctionnels électroniques, tels que les circuits de commutation, les composants de circuit, les récepteurs, les capteurs et similaires, pour la détection et l'exploitation de grandeurs de mesure influençant la conduite du véhicule automobile contre des rayonnements électromagnétiques, des couplages capacitifs et similaires, **caractérisé en ce que** l'on procède à une division des unités et/ou groupes fonctionnels en unités et/ou groupes partiels (S1 ; S2, A1, A2 ; D, CAN) qui présentent une sensibilité différente à l'égard des facteurs de perturbation, **en ce qu'**aux unités et/ou groupes partiels présentant une sensibilité différente à l'égard des facteurs de perturbation est associé un blindage différent contre les facteurs de perturbation, **en ce que** les blindages (4, 5, 8) sont réalisés sous la forme d'un boîtier électriquement conducteur, **en ce que** les unités et/ou groupes partiels présentant une sensibilité différente sont séparés par des boîtiers les enfermant en cascade, **en ce qu'**au moins deux des boîtiers se complètent en un blindage (4, 5 ; 5, 8) de rendement ou facteur supérieur et les unités et/ou groupes partiels sont reliés chacun au système de régulation par des lignes (1, 2, 12, 14, 23, 24, 25, 26) ressortant des boîtiers.

2. Système de régulation de véhicule automobile selon la revendication 1, **caractérisé en ce que** les unités et/ou groupes partiels sont reliés à des lignes (1, 2, 13, 15, 23, 24, 25, 26) passant à travers les boîtiers (4, 5, 8), lesquelles sont raccordées aux boîtiers (4, 5, 8) chacune de manière capacitive par l'intermédiaire de condensateurs (C1, C2, C3 ; C4, C5, C6, C7; C8 à C13), ou chacune de manière capacitive par l'intermédiaire des condensateurs (C1, C2, C4, C5, C6 ; C8 à C13) et de manière galvaniquement conductrice, par l'intermédiaire d'un pont (B3, B7).

3. Système de régulation de véhicule automobile selon l'une des revendications 1 ou 2, **caractérisé en ce qu'**un premier boîtier (4), recevant l'unité et/ou groupe partiel sensible est entouré par au moins un autre boîtier (5) ou (8) dans lequel est disposée une autre unité et/ou groupe partiel (S1, A1, A2).

4. Système de régulation de véhicule automobile selon l'une des revendications 1 à 3, **caractérisé en ce que** sur un boîtier terminal (8) entourant tous les boîtiers (4, 5) est prévu un élément à enfichage (7) auquel sont reliées toutes les lignes (23, 24, 25, 26) des unités et/ou groupes partiels (D, CAN) disposés dans le boîtier terminal (8).

5. Système de régulation de véhicule automobile selon l'une des revendications 1 à 4, **caractérisé en ce que** les lignes (1, 22, 23, 24, 25) amenées à l'élément à enfichage (7) sont reliées chacune par un condensateur (C8, C9, C10, C11, C12), à un élément de raccordement (9) qui est raccordé de manière capacitive au boîtier terminal (8), par l'intermédiaire d'un condensateur (C13).

6. Système de régulation de véhicule automobile selon l'une des revendications 1 à 5, **caractérisé en ce que** l'unité et/ou groupe partiel, disposé dans le premier boîtier (4), est un capteur d'embardée.

7. Système de régulation de véhicule automobile selon l'une des revendications 1 à 6, **caractérisé en ce que** l'unité et/ou groupe partiel disposé dans un deuxième boîtier (5) entourant le premier boîtier (4), est un capteur d'accélération transversale (S2) et comporte des étages de traitement de signaux (A2) pour le capteur d'accélération transversale et le capteur d'embardée.

8. Système de régulation de véhicule automobile selon l'une des revendications 1 à 7, **caractérisé en ce que** l'unité et/ou groupe partiel disposé dans un troisième boîtier (8) entourant le premier et le deuxième boîtier (4, 5), est un réseau (D), en particulier un processeur de signaux, et une interface de bus.

9. Système de régulation de véhicule automobile selon l'une des revendications 1 à 8, **caractérisé en ce que** les boîtiers (4, 5, 8) sont reliés entre eux par des éléments de couplage (10) amortissant les oscillations.

10. Système de régulation de véhicule automobile selon l'une des revendications 4 à 9, **caractérisé en ce que** le boîtier terminal (8) est relié avec contact métallique à un élément, dissipant la chaleur, d'un véhicule automobile.
